# EUROPÄISCHE PATENTSCHRIFT

(11) **EP 0 971 310 B1**
(45) Veröffentlichungstag und Bekanntmachung des Hinweises auf die Patenterteilung: **27.03.2002**
(21) Anmeldenummer: 99116694.3
(22) Anmeldetag: 13.05.1996
(51) Int. Cl.: G06K 15/12, B41J 2/45, H04N 1/40

(54) **Optischer Zeichengenerator für ein elektrografisches Druck- oder Kopiergerät**
Optical character generator for an electrographic printer or copier
Générateur de caractères optiques pour imprimante ou copieur électrographique

(30) Priorität: 22.05.1995 EP 95107809
(43) Veröffentlichungstag der Anmeldung: 12.01.2000
(62) Teilanmeldung aus: 96916051.4
(73) Patentinhaber: Océ Printing Systems GmbH, 85586 Poing (DE)
(72) Erfinder: MORRIS, Edward, 85435 Erding (DE); EICHSTETTER, Josef, 85604 ZORNEDING (DE); FAUST, Martin, 85305 JETZENDORF (DE); JÖRGENS, Klaus-Dieter, 85598 BALDHAM (DE); KLAPETTEK, Gerhard, 35396 GIESSEN (DE); LÖW, Alfons, 86836 OBERMEITINGEN (DE); PACHONIK, Klaus, 82024 TAUFKIRCHEN (DE)
(74) Vertreter: Schaumburg, Thoenes & Thurn

(56) Entgegenhaltungen:
- EP-A- 0 335 553
- EP-A- 0 480 650
- EP-A- 0 504 575
- EP-A- 0 630 148
- US-A- 4 734 714

## Beschreibung

Die Erfindung betrifft einen optischen Zeichengenerator für ein elektrografisches Druck- oder Kopiergerät. Optische Zeichengeneratoren haben die Aufgabe, die in Form von elektronischen Daten vorliegenden Druckinformationen in ein optisches Bild umzusetzen, mit dem dann eine fotoleitende Schicht, z.B. einer Fotoleitertrommel, belichtet wird. Danach wird das belichtete Bild in bekannter Weise entwickelt und z. B. auf Papier umgedruckt.

Von Vorteil sind optische Zeichengeneratoren, die zeilenartig aufgebaut sind, da diese ohne mechanische Bewegung arbeiten. Bei dieser Art der Zeichengenerierung muß für jeden Punkt, der innerhalb einer Zeile abgebildet werden soll, eine eigene separate Lichtquelle vorhanden sein. Die Anzahl der Lichtquellen ist dadurch sehr groß (mehrere 1000). Alle Lichtquellen müssen die fotoleitende Schicht - identische Einfärbung vorausgesetzt - generell mit der gleichen Lichtenergie belichten, damit im Ergebnis eine optimale Qualität des Schriftbildes erreicht wird.

Zur Wiedergabe einer Schwarz/Weiß-Bildinformation, zu der eine gleichmäßige Belichtung an jedem Bildpunkt erforderlich ist, ist aus US-4 734 714 ein optischer Zeichengenerator mit einem LED-Dioden-Array bekannt. Die LED-Arrays sind auf einem Substrat in einer Reihe nacheinander so angeordnet, daß sie eine Druckzeile bilden, in der für jedes wiedergebbare Pixel eine Lichtquelle vorhanden ist. Jedem LED-Array sind zwei Steuerbausteine zugeordnet, deren Anschlüsse über Leiterbahnen auf dem Substrat zu den Anschlüssen der LED-Arrays geführt sind. Eine Verbindung zwischen Leiterbahn und LED-Array erfolgt durch Bonden. Während der eine Steuerbaustein für die Ansteuerung der ungeradzahligen lichtemittierenden Dioden zustandig ist, ist der andere Steuerbaustein für die Ansteuerung der geradzahligen lichtemittierenden Dioden zuständig. Die Steuerbausteine enthalten Schieberegister in die die 1 Bit breite Bildinformation seriell getaktet werden kann. Der Ausgang des Schieberegisters eines ersten Steuerbausteins ist mit dem Eingang eines Schieberegisters eines zweiten Steuerbausteins verbunden, so daß Daten, die in den ersten Steuerbaustein eingeschrieben werden, an den zweiten und auch an weiter nachgeordnete Steuerbausteine durchgereicht werden können. Zur Verminderung der Taktrate beim Einschieben in das Schieberegister ist vorgeschlagen, einzelne Gruppen von Steuerbausteinen zu bilden, deren Schieberegister in der oben beschriebenen Weise gekoppelt sind. Um die abgegebene Lichtenergie jeder einzelnen lichtemittierenden Diode so einzustellen, daß die Streubreite der abgegebenen Lichtleistung benachbarter lichtemittierender Dioden begrenzt ist, ist vorgeschlagen, den einzelnen Treiberbauelementen der Steuerbausteine Strombegrenzungsmittel in Form von Widerständen oder Transistoren hinzuzufügen.

Die Bildinformation beim bekannten Zeichengenerator umfaßt 1 Bit pro Pixel. Bei neueren Anwendungen werden jedoch Zeichengeneratoren benötigt, die zur Wiedergabe von Grauwertbildinformation oder Farbbildinformantion geeignet sind. Bei einer solchen Bildinformation Umfaßt ein Pixel mehrere Bit. Entsprechend müssen zur Ansteuerung einer einzelnen Lichtquelle eine Vielzahl von Bit parallel zur Verfügung gestellt werden.

Aus der EP-A-0 504 575 ist ebenfalls ein Zeichengenerator mit einem LED-Dioden-Array bekannt. Bauartbedingt ist jedoch auch dieser Zeichengenerator kaum dazu geeignet, mehrere Bits umfassende Grauwertinformationen gleichzeitig darzustellen.

Der vorliegenden Erfindung liegt deshalb die Aufgabe zu Grunde, einen optischen Zeichengenerator für ein elektrografisches Druck- oder Kopiergerät aufzuzeigen, der ein schnelles Heranführen einer mehrere Bit umfassenden Bildinformation zu jeder einzelnen Lichtquelle bei hoher Zuverlässigkeit und Präzision ermöglicht.

Diese Aufgabe wird durch die im Patentanspruch 1 angegebenen Merkmale gelöst. Weiterbildungen und Ausgestaltungen der Erfindung sind in Unteransprüchen angegeben.

Die Strombelastung der Energieversorgung des Zeichengenerators wird durch einen zu jeder Lichtquelle parallel geschalteten Verbraucher, insbesondere einen Shunt-Transistor, von unerwünschten Störspitzen befreit. Insbesondere bei der Verwendung von Leuchtdioden als Lichtquellen, die eine Schwellspannung aufweisen, läßt sich mit einer derartigen Anordnung das Einschalten und das Ausschalten der Lichtquelle so steuern, daß die Energiezufuhr zum Zeichengenerator vorübergehend unabhängig vom Aktivieren der Lichtquellen erfolgen kann.

Nachfolgend wird ein Beispiel der Erfindung anhand der Zeichnung näher erläutert. Dabei zeigen
- Figur 1: eine blockweise Darstellung eines Zeichengenerators mit Stromversorgung und Steuerung,
- Figur 2: eine schematische Darstellung des Zeichengenerators in Draufsicht, mit Träger und Flachbaugruppe,
- Figur 3: eine blockweise Darstellung der Funktionselemente eines Mittels zur Steuerung von Lichtquellen,
- Figur 4: ein Blockschaltbild der Verbindung von Referenzwiderständen mit den Mitteln zur Steuerung von Lichtquellen,
- Figur 5: eine Rampschaltung zum Einschalten von Lichtquellen,
- Figur 6: eine Schnittdarstellung des Zeichengenerators mit einem Schnittverlauf senkrecht zu seiner Längserstrekkung,
- Figur 7: einen Ausschnitt aus der Schnittdarstellung gemäß Figur 6 mit Stromschiene, Flachbaugruppe und Träger und
- Figur 8: eine Taktversorgung der Datenspeicher in der Art eines Schieberegisters.

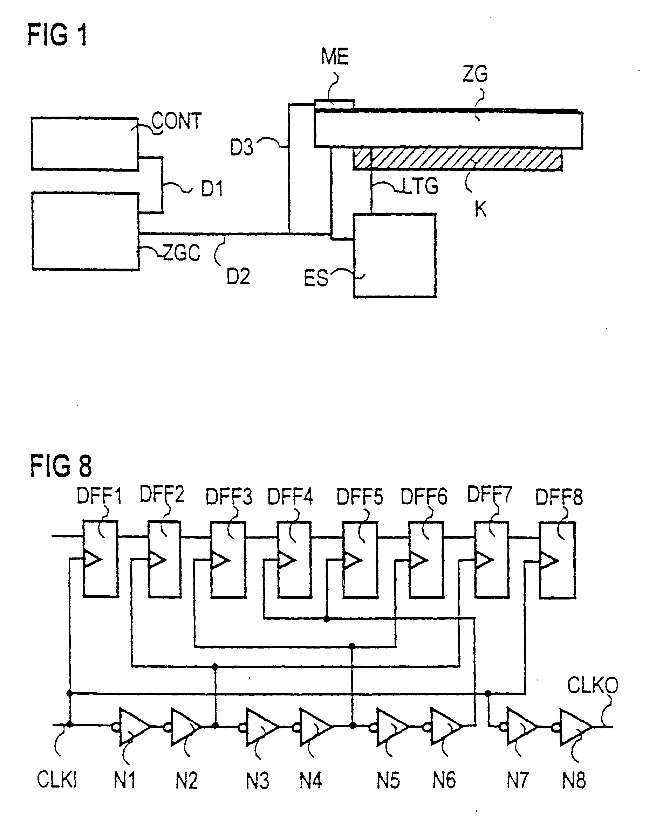

Ein optischer Zeichengenerator ZG eines elektrografischen Druck- oder Kopiergerätes ist gemäß Figur 1 mit einem Controller CONT einer Zeichengeneratorsteuerung ZGC und einer Stromversorgung ES verbunden. Im Controller CONT werden in einer bekannten Druckersprache, wie z.B. IPDS, PCL, POSTSCRIPT, kodierte Bildinformationen in ein Raster aus einzelnen Bildpunkten, einem sogenannten Bitmap umgewandelt. Dieses Bitmap wird über einen ersten Datenbus mit einer Breite von 32 Bit zur Zeichengeneratorsteuerung ZGC übertragen. Optional kann die Übertragung auch mit anderen Busbreiten oder mit einem seriellen Bus erfolgen.

Die Zeichengeneratorsteuerung ZGC steuert alle Funktionen des Zeichengenerators ZG. Dabei wird die Information des Bitmap in eine auf die Komponenten des Zeichengenerators ZG abgestimmte Einschaltinformation für jede einzelne Lichtquelle LED umgesetzt. Im folgenden werden lichtemittierende Dioden LED, die im Zeichengenerator ZG als Lichtquellen dienen, durch das Kürzel LED bezeichnet. Von der Zeichengeneratorsteuerung ZGC werden diese LED-spezifischen Einschaltinformationen über einen zweiten Datenbus D2 zum Zeichengenerator ZG übertragen. Die Breite des zweiten Datenbusses D2 hängt von der Übertragungsrate ab, die mit der Länge des Zeichengenerators ZG der Bildauflösung in dpi (dots per inch), der Druckgeschwindigkeit und der Anzahl der Grauwert- oder Farbabstufungen variiert. Im vorliegenden Beispiel beträgt die Druckbildauflösung 600 dpi und die Anzahl der mit den Grauwertstufen in Verbindung stehenden Belichtungsstufen 256. Jede LED auf dem Zeichengenerator ZG muß der Anzahl der Belichtungsstufen folgend mit einem Byte der Breite 8 Bit als Einschaltdauerinformation versorgt werden.

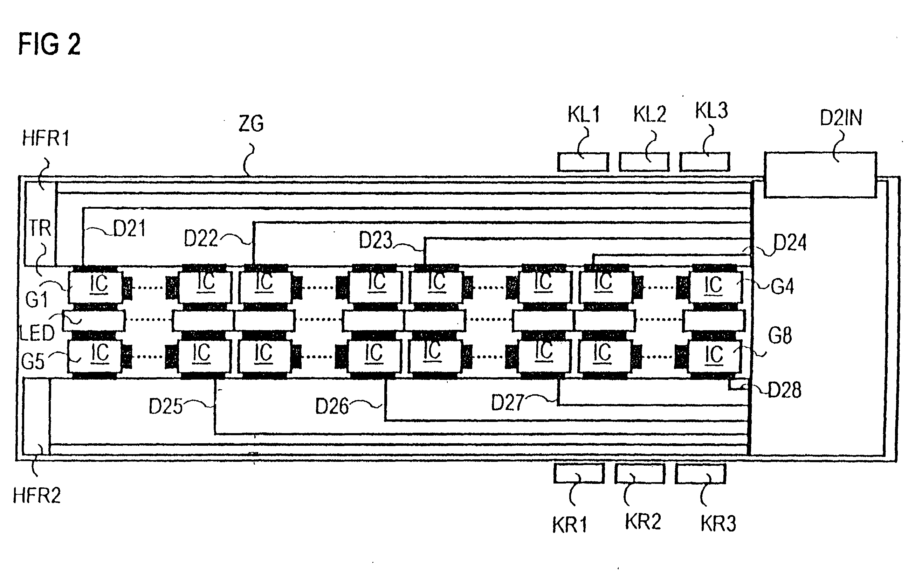

Wie aus der Draufsicht gemäß Figur 2 auf den Zeichengenerator ZG hervorgeht, enthält der Zeichengenerator ZG acht Gruppen G1..G8 von LEDs, die jeweils mit einer acht Bit breiten Datenleitung D21..D28 des zweiten Datenbusses D2 verbunden sind. Die gesamte Breite des zweiten Datenbusses D2 beträgt somit 64 Bit. Dieser zweite Datenbus D2 ist mit einem Dateneingang D2IN des Zeichengenerators ZG verbunden. Über diesen Dateneingang D2IN gelangen die Daten zu einer Flachbaugruppe FBG des Zeichengenerators ZG. Auf der Flachbaugruppe FBG werden die Datenleitungen des zweiten Datenbusses D2 in einzelne gruppenspezifische Datenleitungen D21..D28 aufgeteilt und jeweils zum Eingang eines integrierten Schaltkreises IC geführt, der als Mittel zur Steuerung der LED dient. Dieser integrierte Schaltkreis IC bildet jeweils das erste einer Mehrzahl von Mitteln zur Steuerung der LEDs, die in den acht Gruppen G1..G8 zusammengefaßt sind. Die Flachbaugruppe FBG kann Verstärkungsmittel enthalten, die eine Signalverstärkung der Daten auf dem zweiten Datenbus D2 bewirken.

Die im Zeichengenerator ZG enthaltene Flachbaugruppe FBG dient nicht nur der Signalzuführung, sondern auch der Energiezufuhr zu den Steuermitteln. Die Flachbaugruppe FBG kann bedarfsweise auch die Energiezufuhr zu den LEDs übernehmen. Dem Zeichengenerator wird die Energie durch eine Stromversorgung ES, die über eine Leitungsverbindung LTG mit dem Zeichengenerator gekoppelt ist, zugeführt. Die Verbindungsleitung LTG ist dazu mit jeweils an den Längsseiten des Zeichengenerators vorgesehenen Anschlüssen KL, KR verbunden. An den Anschlüssen KL1, KR1 erfolgt die Masseverbindung GND, an den Anschlüssen KL2, KR2 liegt eine Spannung von 3,1 Volt und an den Anschlüssen KL3, KR3 liegt eine Spannung von 5,4 Volt. Der Betrag dieser Spannungen hängt von der verwendeten Technologie bei den integrierten Schaltkreisen IC und bei den LEDs ab.

Wie weiter aus der Figur 2 entnehmbar ist, sind die LEDs mittig in der Längserstreckung des Zeichengenerators ZG auf einem Träger TR in einer Reihe, die eine Druckzeile bildet, angeordnet. Die Anzahl der LEDs pro Längeneinheit entspricht der Anzahl der Bildpunkte pro Längeneinheit. Beträgt die Anzahl der Bildpunkte pro Längeneinheit 600 dpi, dann sind entsprechend auf dieser Distanz 600 LEDs in einer Reihe angeordnet. Die einreihige Anordnung der LEDs hat den Vorteil, daß eine eventuelle Reparatur des Zeichengenerators erleichtert wird. Die LEDs können nicht als diskrete Bauelemente nebeneinander angeordnet werden, sondern sind auf einem Halbleiterchip aus Galiumarsenid abschnittsweise zusammengefaßt. Auf einem Halbleiterchip sind 64 LEDs angeordnet. Ein solcher Halbleiterchip wird im folgenden als LED-Array bezeichnet. Die LED-Arrays haben rechteckige Form und sind unmittelbar auf den Träger TR geklebt.

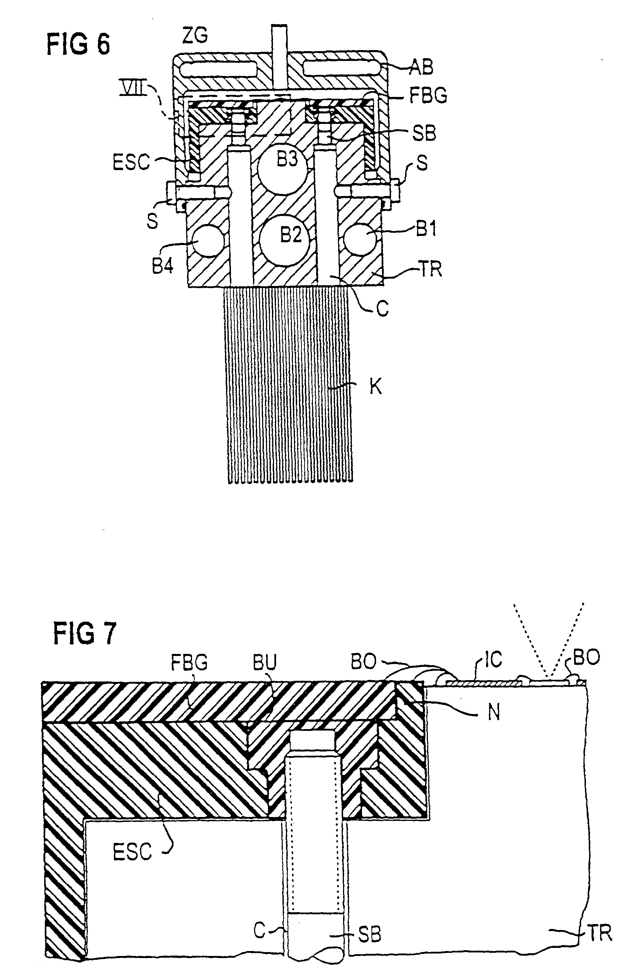

Beiderseits jedes LED-Arrays ist je ein integrierter Schaltkreis IC angeordnet, der ebenfalls unmittelbar auf den Träger geklebt ist. Die Befestigung der Bauelemente kann optional auch durch Leitkleber, durch ein Lot oder ähnliches erfolgen. Wie auch aus den Figuren 6 und 7 entnehmbar ist, schließt sich an die von LED-Array abgewandte Seite jedes ICs ein Flügel der Flachbaugruppe FBG an. Die Flachbaugruppe FBG erstreckt sich von der Stirnseite des Zeichengenerators ZG, an der der Datenanschluß D2IN vorgesehen ist, in zwei Flügeln beiderseits der auf dem Träger TR angeordneten LED-Arrays und ICs. Das vom Dateneingang D2IN abgewandte Ende jedes Flügels der Flachbaugruppe FBG ist auf Grund der hohen Datenrate mit einem Abschlußwiderstand HFR1, HFR2 abgeschlossen.

In der Schnittdarstellung gemäß Figur 6 erkennt man den weiteren Aufbau des Zeichengenerators ZG. Die Form des Trägers TR ist im wesentlichen rechteckig. Der Träger TR besteht aus Metall, das zur Erhöhung der Längssteifigkeit und/oder zu Zwecken einer Wasserkühlung mit Längsbohrungen B1..B4 versehen ist. Der Träger TR ist an seiner Unterseite mit einem Kühlkörper K gekoppelt. Auf der dem Kühlkörper K gegenüberliegenden Oberseite des Trägers TR sind die Flachbaugruppe FBG, die ICs und die LED-Arrays angeordnet. Diese Oberseite ist durch eine Abdeckung AB nach oben abgeschirmt. Die Abdekkung AB ist haubenartig ausgeführt und umgreift den Träger TR teilweise. An den Seitenwänden des Trägers TR anliegende Schenkel der Abdeckung sind durch Schraubverbindungen S lösbar am Träger TR fixiert. Die Abdeckung AB ist in ihrem sich auf der Oberseite des Trägers TR erstreckenden Teil als Hohlprofil ausgeführt, das im Strahlungsbereich der LED eine sogenannte Selfog-Linse zur Fokussierung der LED-Strahlung enthält.

Wie insbesondere aus der Detaildarstellung gemäß Figur 7 entnehmbar ist, ist der Träger TR im oberen Teil durch eine Stromschiene ESC und die Flachbaugruppe FBG zu seiner rechteckigen Querschnittsform ergänzt. Die Stromschiene ESC weist ein L-förmiges Profil auf, das in eine entsprechende Ausnehmung des Trägers TR einlegbar ist. Zwischen dem Träger TR und der Stromschiene ESC ist ein nicht dargestellter Isolator eingebracht, um eine elektrische Verbindung zwischen den beiden Bauteilen zu verhindern. Die Stromschiene ESC weist entlang ihrer Erstreckung mehrere Durchdringungen C auf, in die von der vom Träger TR abgewandten Seite elektrisch nicht leitende Gewindebuchsen BU einbringbar sind. In diese Gewindebuchsen BU dringen zur Befestigung der Stromschiene ESC am Träger TR Schrauben SB ein, die durch die zwischen Ober- und Unterseite des Trägers TR verlaufenden Durchdringungen C führbar sind. Diese Art der Befestigung zwischen dem Träger TR und der Stromschiene ESC weist den Vorteil auf, daß die auf der Oberseite des Trägers TR in die Stromschiene ESC eingebettete Flachbaugruppe FBG durch die Art der Befestigung nicht beeinträchtigt wird. So braucht bei der Leiterbahnführung auf der Flachbaugruppe FBG nicht auf etwaige Durchdringungen zur Befestigung der Stromschiene ESC geachtet werden.

Die Flachbaugruppe FBG ist in eine dem Querschnitt der Flachbaugruppe FBG entsprechende Ausnehmung auf der Oberseite der Stromschiene ESC eingebettet. Die Flachbaugruppe FBG ist mit der Stromschiene ESC vollflächig verbunden. Dazu eignet sich insbesondere eine flächige Verklebung mit einem elektrisch nicht leitfähigen Kleber. Durch die vollflächige Verbindung zwischen den beiden Bauteilen wird die durch die L-Form der Stromschiene ESC erreichte Längssteifigkeit auch für die sich beispielsweise über eine Länge von etwa 70 cm erstreckende Flachbaugruppe FBG genutzt.

Zwischen den an den Längsseiten des Trägers TR verlaufenden Stromschienen ESC, verbleibt ein Stück Oberfläche des Trägers TR, auf dem in oben beschriebener Weise die LED-Arrays mit ihren beiden jeweils benachbarten ICs aufgebracht sind. Der Träger TR dient dabei als Masseleitung, die durch die leitfähige Verklebung zu den integrierten Schaltkreisen IC und den LED-Arrays kontaktiert ist. Die erforderlichen elektrischen Verbindungen zwischen den integrierten Schaltkreisen IC und den LED-Arrays, sind unmittelbar durch von einer Kontaktfläche des ICs zu einer Kontaktfläche des LED-Arrays geführte Bondverbindungen BO hergestellt. Durch ebensolche Bondverbindungen BO sind auch die elektrischen Verbindungen zwischen Kontakten der Flachbaugruppe FBG und der Stromschiene ESC mit dem integrierten Schaltkreis IC ausgeführt. Auch die Masseverbindung vom Träger TR zum IC und/oder zum LED-Array kann wahlweise durch Bonden BO hergestellt werden. Um eine Bondverbindung BO zwischen der Stromschiene ESC und dem IC zu ermöglichen, weist die Stromschiene ESC eine Kontaktnase N auf, die sich von einem Schenkel der Stromschiene ESC senkrecht zu diesem in Richtung der Trägeroberseite erstreckt. Die Kontaktnase N erstreckt sich entlang der Trägeroberseite, auf der die ICs und LED-Arrays angeordnet sind und befindet sich somit zwischen der Flachbaugruppe FBG und der Trägeroberseite. Durch entsprechende Beschichtung der Oberfläche der Kontaktnase N kann die Bondung BO durch das sogenannte Wetch-Verfahren vorgenommen werden.

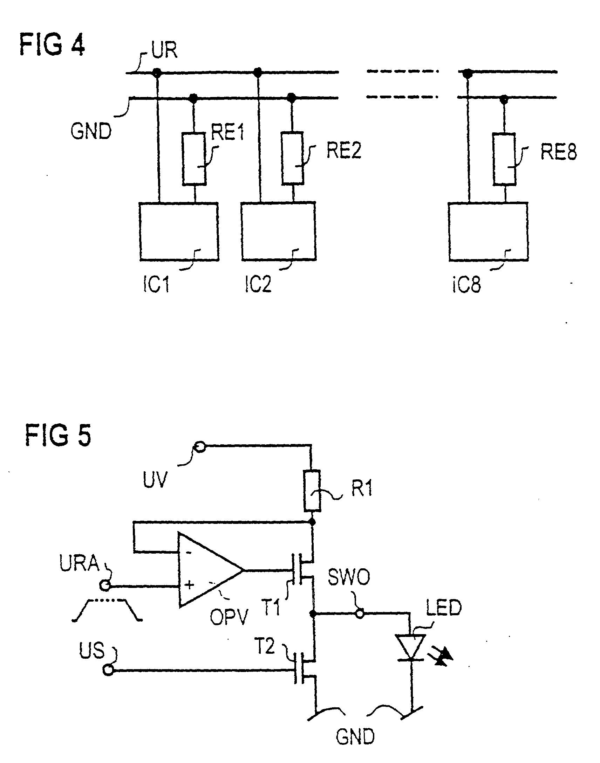

Durch die Verwendung von Bondverbindungen BO von der Flachbaugruppe FBG zum IC ist eine einfache Verbindungsmöglichkeit aufgezeigt, durch die eine Anordnung von Glättungskondensatoren und Referenzwiderständen RE1..RE4 (siehe Figur 4) auf der Flachbaugruppe FBG auf einfache Weise realisierbar ist. Durch solche diskret bestückbaren Bauelemente können niedrigere Toleranzwerte der Bauelemente erreicht werden. Mit niedrigen Toleranzwerten ist eine hohe Qualität der mit dem Zeichengenerator ZG durchgeführten Belichtung eines fotoleitfähigen Materials, wie z.B. einer Fotoleitertrommel, erreichbar.

Die Daten werden durch die Datenleitungen D21..D28 des zweiten Datenbusses D2 an den jeweils ersten IC über die Flachbaugruppe FBG herangeführt. Die Verbindung zwischen den Datenleitungen D21..D28 und den integrierten Schaltkreisen IC erfolgt durch die Bondverbindungen BO. Die ICs enthalten Schieberegister SR, durch die die Daten geschoben werden. Der Ausgang der Schieberegister SR ist jeweils mit dem Eingang des Schieberegisters SR des nachfolgenden ICs unmittelbar durch eine Bondverbindung BO gekoppelt. Bei einer Wortbreite von 8 Bit, werden dementsprechend 8 Bondverbindungen BO mit insgesamt 16 Kontakten benötigt. Es werden also gegenüber einer indirekten Verbindung der Schieberegister SR über die Flachbaugruppe FBG 16 Kontaktierungen und 8 Leiterbahnen auf der Flachbaugruppe FBG pro Schieberegisterverbindung eingespart. Dies erhöht die Zuverlässigkeit des Zeichengenerators und verringert seine Baugröße. Der Abstand und die Breite der Leitungen können infolge dessen optimiert werden. Dies bedingt eine Steigerung der Fertigungsqualität und der Ausbeute an fehlerfreien Flachbaugruppen FBG bei der Fertigung.

Bei der dargestellten Ausführungsform sind jedem LED-Array zwei ICs zugeordnet. In jedem LED-Array sind 128 LEDs enthalten, von denen die geradzahligen LEDs vom IC einer ersten Gruppe G1..G4 und deren ungeradzahlige LEDs von einem IC einer anderen Gruppe G5..G8 angesteuert werden. Jeder integrierte Schaltkreis IC steuert damit 64 LEDs an. Folglich sind 64 Datenworte a 8 Bit in einem IC zu verarbeiten.

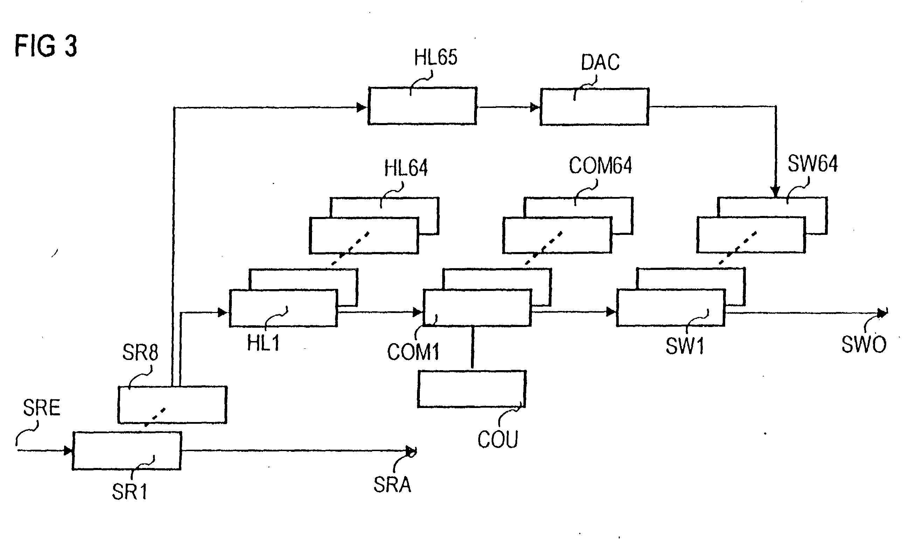

Figur 3 zeigt eine blockweise Darstellung der Funktionselemente eines ICs. Der Dateneingang SRE des ICs wird durch den Schieberegistereingang SRE mit einer Breite von 8 Bit gebildet. Jedes Bit wird einem von 8 parallelen Schieberegistern SR1..SR8 zugeführt. Die Schieberegisterlänge beträgt 64 Bit, wodurch beim Einschieben des 65. Bit das erste Bit über den Schieberegisterausgang SRA zum nachfolgenden IC weitergereicht wird. Somit stehen am Ende des Schiebevorgangs 64 Datenworte zur Steuerung der Einschaltzeit von 64 LEDs im IC zur Verfügung.

Da durch den IC nicht nur eine individuelle Steuerung der Einschaltzeit jeder LED einer Gruppe von LEDs steuert, sondern auch eine durchschnittliche Energiezufuhr für alle LEDs dieser Gruppe eingestellt werden soll, enthält der IC einen Digital-Analog-Wandler DAC, mit Hilfe dessen die durchschnittliche Energiezufuhr zu den LEDs einstellbar ist. Diesem Digital-Analog-Wandler DAC wird die einzustellende Energiezufuhr in Form eines Datenwortes, das beispielsweise 6 Bit Breite aufweist, zugeführt. Die Zufuhr kann zum einen durch einen gesonderten Datenbus erfolgen oder aber in besonders vorteilhafter Weise als ein Datenwort innerhalb des Bilddatenstromes. Bei der letztgenannten Ausführungsform ist eine entsprechende Länge der Schieberegister SR1..SR8 von 65 Bit zu wählen.

Als erste den Schieberegistern SR1..SR8 nachgeschaltete Funktionsstufe sind 65 Zwischenspeicher HL1..HL65 vorgesehen, in die die 8 Bit breiten Datenworte aus den Schieberegistern SR1..SR8 parallel übernommen werden. In den für den Digital-Anaiog-Wandler DAC bestimmten Zwischenspeicher HL65, wird entsprechend ein Datenwort übernommen.

Den Zwischenspeichern HL1..HL64 als zweite Funktionsstufe nachgeschaltet, sind 8 Bit Komparatoren COM1..COM64 vorgesehen. Die Komparatoren COM1..COM64 vergleichen das in dem jeweils zugehörigen Zwischenspeicher HL1..HL64 hinterlegte Datenwort mit dem Zählerstand eines Zählers COU, der mit allen Komparatoren COM1..COM64 gekoppelt ist. Der Zähltakt wird von außen zugeführt. Diese Zufuhr von außen führt zu einer einfacheren Programmierbarkeit des Taktgenerators. Erreicht der Zählerstand, ausgehend von einem Startsignal für die Belichtung und dem damit einhergehenden Zählerstand 0, den im Zwischenspeicher HL1..HL64 hinterlegten Wert, dann ändert sich mit dem nächsten Zählschritt die 1 Bit Ausgangsinformation des Komparators COM1..COM64.

Als dritte Funktionseinheit des IC sind den Komparatoren COM1..COM64 64 analoge Schaltmittel SW1..SW64 nachgeordnet. Diese Schaltmittel SW1..SW64 werden von der Ausgangsinformation der Komparatoren COM1..COM64 gesteuert. Abhängig vom individuellen Datenwort werden mit Beginn des Zählvorgangs die einzelnen LEDs durch das ihnen jeweils zugeordnete Schaltmittel SW1..SW64 des IC eingeschaltet. Zum Beispiel wird bei einem Datenwort mit dem Wert 0 eine LED nicht eingeschaltet, während bei einem Datenwort mit dem Wert 150 die entsprechende LED eingeschaltet wird. Der Zähler COU erreicht den Zählerstand 150 und der Komparator COM1..COM64 erzeugt beim Übergang zum Zählerstand 151 ein 1 Bit breites Signal, das mittels des Schaltmittels SW ein Abschalten der entsprechenden LED bewirkt. Der Ausgang SWU jedes Schaltmittels ist zu einer Kontaktfläche des ICs geführt, auf dem die Bondverbindung BO zum LED erfolgen kann.

Der während der Einschaltzeit an die LED abgegebene Strom wird durch den Digital-Analog-Wandler DAC bestimmt. Dem Digital-Analog-Wandler DAC wird gemäß Figur 4 eine Referenzspannung UR zugeführt. Der Digital-Analog-Wandler DAC ist zudem mit einem auf der Flachbaugruppe FBG angeordneten und einseitig an Masse angeschlossenen Referenzwiderstand RE1..RE8 verbunden. Mit Hilfe dieses Referenzwiderstandes RE1..RE8 wird ein Referenstrom erzeugt, der in die Treibertransistoren T1 der Schaltmittel SW1..SW64 gespiegelt wird. Mit Hilfe eines entsprechenden Temperaturbeiwerts des Referenzwiderstandes RE1..RE8, kann auf diese Weise eine Temperaturkompensation erreicht werden. Eine Treiberstufe der Schaltmittel SW1..SW64 ist in Figur 5 gezeigt. Die Treiberstufe ist als sogenannte Rampschaltung ausgebildet und besteht aus einem Operationsverstärker OPV, dessen Ausgang mit dem Steuereingang des Treibertransistors T1 verbunden ist. Der Treibertransistor T1 ist als Feldeffekttransistor bestimmter Polarität aufgezeigt. Es könnte jedoch sowohl ein Feldeffekttransistor anderer Polarität als auch ein Transistor einer anderen Technologie, wie z.B. der bipolaren, verwendet werden. Der Draineingang des Treibertransistors T1 ist zum einen mit dem invertierenden Eingang des Operationsverstärkers OPV und zum anderen mit einem Anschluß eines Arbeitswiderstandes R1 verbunden. Der andere Anschluß des Arbeitswiderstandes R1 ist mit der Versorgungsspannung UV verbunden. Der Sourceanschluß des Treibertransistors T1 bildet den Schaltmittelausgang SWO. An diesem Schaltmittelausgang SWO ist die Anode der LED angeschlossen. Die Kathode dieser LED liegt an Masse GND. Parallel zur LED liegt die Drain-Source-Strecke eines Shunt-Transistors T2. Der Steuereingang dieses Shunt-Transistors T2 ist mit dem Eingang OS zum Schalten der LED gekoppelt.

Durch die beschriebene Rampschaltung können Spannungsstörungen vermieden werden. Da die LEDs aller LED-Arrays auf einer Linie angeordnet sind, müssen sie gleichzeitig eingeschaltet werden. Bei diesem gleichzeitigen Einschaltvorgang fließt in der Summe ein großer Strom. Auf Grund dieses hohen Stromstoßes kommt es zu Induktivititätsproblemen mit der Stromschiene ESC. Diese Probleme werden mit der Rampschaltung vermieden, weil der Strom relativ langsam und kontrolliert "hochgefahren" werden kann und dennoch ein schnelles Einschalten der LEDs gewährleistet ist. Bevor die LEDs eingeschaltet werden, wird der Strom mit vordefinierten Stromanstiegsraten hochgefahren, bis der gewünschte LED Stromwert durch den zur LED parallelgeschalteten Shunt-Transistor T2 fließt. Der Strom wird mittels des beschriebenen Stromspiegels IC spezifisch eingestellt. Nachdem der Strom stabil fließt, wird der Shunt-Transistor T2 ausgeschaltet. Der nun durch die LED fließende Strom hat den gleichen Betrag wie der vorherige Strom durch den Shunt-Transistor T2. Der Ausschaltvorgang verläuft analog zum eben beschriebenen Einschaltvorgang. Durch Einschalten des Shunt-Transistors T2 fließt der im Betrag unveränderte Strom nicht mehr über die LED. Sodann wird der Strom mit einer vordefinierten Abfallrate bis zum Wert 0 "heruntergefahren". Da der Strom zu keinem Zeitpunkt eine steile Flanke aufweist, können auch keine unerwünschten Störspannungen erzeugt werden. Der Flankenanstieg wird durch eine Rampspannung URA, die am nicht invertierenden Eingang des Operationsverstärkers OPV anliegt, eingestellt. Der mit den Ramp-Schaltungen erreichbare Effekt der Vermeidung von Spannungsstörungen läßt sich dadurch verbessern, daß benachbarte Shunt-Transistoren zeitversetzt zueinander geschaltet werden.

Figur 8 zeigt eine spezielle Taktversorgung der Datenspeicher in der Art eines Schieberegisters SR1..SR8. Die nachfolgend beschriebene Taktversorgung verringert das Schaltrauschen, das bei konventioneller Taktversorgung auftreten würde, ohne eine wesentliche Verzögerung der Signallaufzeit zu bedingen.

Im Inneren der Schieberegister SR1..SR8 sind einzelne D-Flip-Flops DFF1..DFF8 hintereinandergeschaltet. Bei einer Registerlänge von 65 Bit werden entsprechend 65 D-Flip-Flops DFF benötigt. Diese D-Flip-Flops sind in Gruppen von beispielsweise 8 D-Flip-Flops DFF1..DFF8 eingeteilt. Innerhalb dieser Gruppen werden das erste und das letzte D-Flip-Flop DFF1, DFF8 mit dem am Eingang der Schieberegistergruppe anliegenden Takt CLK1 versorgt. Der Eingangstakt wird durch zwei hintereinandergeschaltete Inverter N1, N2 verzögert. Dieser so verzögerte Takt wird dem zweiten und siebten D-Flip-Flop DFF2, DFF7 zugeführt. Eine weitere Verzögerung des Taktes erfolgt durch die hintereinandergeschalteten Inverter N3, N4. Dieser weiter verzögerte Takt wird dem dritten und dem sechsten D-Flip-Flop DFF3, DFF6 zugeführt. Das vierte und fünfte D-Flip-Flop DFF4, DFF5, werden von einem durch die hintereinandergeschalteten Inverter N5, N6 weiter verzögerten Takt versorgt. Der am Takteingang CLK1 anliegende Takt wird nicht unmittelbar zu einem Taktausgang CLKO geführt, sondern über zwei weitere Inverter N7, N8 verzögert an die nächstfolgende Registergruppe abgegeben. Durch diese letztgenannte Verzögerung durch die Inverter N7, N8 ist sichergestellt, daß auch die Taktsignale für unterschiedliche Registergruppen untereinander zeitversetzt sind.

Die Daten, die durch die Schieberegister SR1..SR8 getaktet werden, werden von der Flachbaugruppe FG zu den jeweils ersten IC einer Gruppe übertragen. Die Datenworte werden in der Zeichengeneratorsteuerung ZGC erzeugt und über den zweiten Datenbus D2 bis zur Flachbaugruppe FBG des Zeichengenerators ZG übertragen. Damit nun die in der Zeichengeneratorsteuerung ZGC erzeugten Datenworte abhängig von der individuellen Lichtstärke einer LED gebildet werden können, muß in bestimmten Zeitabständen eine diesbezügliche Korrekturinformation ermittelt werden. Zu diesem Zweck wird eine Meßeinrichtung ME eingesetzt, die die individuellen Leuchtstärken ermittelt. Eine solche Meßeinrichtung ist aus US-4 780 731 bekannt. Sie umfaßt einen Meßschlitten, auf dem lichtsensitive Sensoren angeordnet sind. Mittels des Schlittens werden die Sensoren über die LED Zeile des Zeichengenerators geführt und durch entsprechende Steuerung die individuelle Lichtintensität jeder LED ermittelt. Die ermittelten Daten werden über einen dritten Datenbus D3 (Figur 1) der Zeichengeneratorsteuerung ZGC zur weiteren Verarbeitung zugeleitet. Dieser Datenbus ist beispielsweise 10 Bit breit. Die Zeichengeneratorsteuerung ZGC verarbeitet diese Daten unmittelbar und erstellt daraus eine Tabelle mit Korrekturwerten. Diese Datenverarbeitung kann jedoch auch außerhalb des Druckers durch entsprechende Datenverarbeitungsgeräte erfolgen. Es müssen dann die entsprechenden Tabellen nachträglich in die Zeichengeneratorsteuerung ZGC geladen werden, damit diese zur Verknüpfung mit den vom Controller CONT gelieferten Grauwert- oder Farbinformationen verknüpft werden können. Aus dieser Verknüpfung werden die Datenworte in Form eines Einschaltdauerbytes generiert und zum Zeichengenerator ZG übertragen.

Die Datenübertragung erfolgt parallel zu den einzelnen IC-Gruppen. Die Datenworte werden durch die Schieberegister SR der ICs getaktet, bis das erste Datenwort das letzte Register des letzten ICs einer Gruppe erreicht hat. Sodann werden die Datenworte in die Zwischenspeicher HL parallel übernommen. Nach dieser Übernahme beginnt der nächste Datenübertragungszyklus bei dem die nächste zu druckende Zeile in die Schieberegister SR getaktet wird. Während der nächste Datenübertragungszyklus abläuft, werden durch die oben beschriebene Art und Weise die einzelnen LEDs abhängig vom individuellen Datenwort für bestimmte Zeit eingeschaltet. Der dazu verwendete Zähler COU kann durch einen nicht dargestellten Oszillator getaktet werden, der im Zeichengenerator ZG oder in der Zeichengeneratorsteuerung ZGC angeordnet werden kann.

Der beschriebene Zeichengenerator ZG kann auch einen geringeren Umfang aufweisen. So kann dieser Zeichengenerator ZG beispielsweise auch lediglich zwei IC-Gruppen umfassen und dabei die volle beschriebene Funktionsfähigkeit erhalten. Es kann auch nur ein IC pro LED-Array eingesetzt werden. Ein solcher Zeichengenerator ZG dient bei unveränderter Länge der Wiedergabe einer Druckbildinformation geringer Auflösung oder bei bleibender hoher Auflösung von beispielsweise 600 dpi, wird seine Länge reduziert. Mehrere Zeichengeneratoren reduzierter Länge können modulartig zu einem Zeichengenerator ZG erhöhter Länge zusammengefügt werden. Damit ist es möglich, diesen Zeichengenerator ZG in verschiedenen Druck- oder Kopiergeräten in unveränderter Bauart einzusetzen, auch wenn diese Geräte unterschiedliche Breiten von Aufzeichnungsträgern verarbeiten.

Bei geringeren Leistungsanforderungen kann auf die oben beschriebene Art der Stromschienen ESC, die den Strom zu den LEDs führen, verzichtet werden. Diese Stromschienen ESC können dann als innere Lage der Flachbaugruppe FBG ausgeführt werden.

### Bezugszeichenliste

- AB: = Abdeckung
- B1..B4: = Längsbohrungen
- BO: = Bondverbindung
- BR: = Gewindebuchse
- CLK1: = Takteingang
- CLKO: = Taktausgang
- COM1..COM64: = Komparator
- CONT: = Controller
- COU: = Zähler
- D1: = Erster Datenbus
- D2: = Zweiter Datenbus
- D21..D28: = Datenleitungen des zweiten Datenbus
- D2IN: = Dateneingang
- D3: = dritter Datenbus
- DAC: = Digital-/Analogwandler
- DFF1..DFF8: = D-Flip-Flop
- ES: = Stromversorgung
- ESC: = Stromschiene
- FBG: = Flachbaugruppe
- G1..G8: = Gruppen
- GND: = Masse
- HFR1, HFR2: = Abschlußwiderstand
- HL1..HL65: = Zwischenspeicher
- IC: = Integrierter Schaltkreis
- K: = Kühlkörper
- LED: = Lichtquelle, Lichtemittierende Diode
- LTG: = Leitungsverbindung
- ME: = Meßeinrichtung
- N: = Kontaktnase
- N1..N8: = Inverter
- OPV: = Operationsverstärker
- R1: = Arbeitswiderstand
- RE1..RE8: = Referenzwiderstand
- S: = Schraubverbindung
- SB: = Schrauben
- SR1..SR8: = Schieberegister
- SRA: = Schieberegisterausgang
- SRE: = Schieberegistereingang
- SW: = Schaltmittel
- SWO: = Schaltmittelausgang
- T2: = Shunt-Transistor
- TR: = Träger
- UR: = Referenzspannung
- URA: = Rampspannung
- US: = Schalteingang
- UV: = Versorgungsspannung
- ZG: = Zeichengenerator
- ZGC: = Zeichengeneratorsteuerung

## Patentansprüche

1. Optischer Zeichengenerator (ZG) für ein elektrografisches Druck- oder Kopiergerät mit
- einer Mehrzahl von in mindestens einer Reihe angeordneten steuerbaren Lichtquellen (LED) und
- mindestens einem Mittel zur Steuerung von Lichtquellen (IC), das pro Lichtquelle (LED) jeweils ein Schaltmittel (SW1,..., SW64) mit einer Treiberstufe (OPV, T1) enthält, die vor dem Einschalten und/oder nach dem Ausschalten der Lichtquelle (LED) derart gesteuert wird, daß an ihrem Ausgang vorübergehend ein Stromfluß durch ein zu der Lichtquelle (LED) parallel geschaltetes und schaltbares Bauelement (T2) erzeugt wird, so daß die Energiezufuhr zum Zeichengenerator (ZG) vorübergehend unabhängig vom Aktivieren der Lichtquellen (LED) erfolgen kann.

2. Optischer Zeichengenerator nach Anspruch 1, **dadurch gekennzeichnet, daß** der Stromfluß steuerbar ist und insbesondere relativ langsam verändert wird.

3. Optischer Zeichengenerator nach Anspruch 2, **dadurch gekennzeichnet, daß** die Steuerung des Stromflusses über eine Steuerspannung (URA) erfolgt, die einen Rampenverlauf hat.

4. Optischer Zeichengenerator nach einem der Ansprüche 1 bis 3, **dadurch gekennzeichnet, daß** zum Einschalten einer Lichtquelle (LED) am Ausgang der Treiberstufe (OPV, T1) ein bis zu einem vorgegebenen Betrag relativ langsam ansteigender Stromfluß durch das parallel geschaltete Bauelement (T2) erzeugt wird und dann die Lichtquelle (LED) durch Ausschalten des parallel geschalteten Bauelements (T2) eingeschaltet wird, wodurch der Stromfluß durch die Lichtquelle (LED) relativ schnell den vorgegebenen Betrag annimmt.

5. Optischer Zeichengenerator nach einem der Ansprüche 1 bis 4, **dadurch gekennzeichnet, daß** zum Ausschalten der Lichtquelle (LED) am Ausgang der Treiberstufe (OPV, T1, T2) das parallel geschaltete Bauelement (T2) eingeschaltet wird, wodurch der zuvor durch die Lichtquelle (LED) fließende Strom nach relativ kurzer Zeit durch das Bauelement (T2) fließt und daß anschließend der durch das Bauelement (T2) fließende Strom mit einer vorgegebenen Charakteristik relativ langsam abfällt.

6. Zeichengenerator nach einem der Ansprüche 1 bis 5, **dadurch gekennzeichnet, daß** jeder Lichtquelle (LED) ein paralleles Bauelement (T2) zugeordnet ist und daß benachbarte, parallele Bauelemente (T2) zeitversetzt zueinander geschaltet werden.

7. Zeichengenerator nach einem der Ansprüche 1 bis 6, **dadurch gekennzeichnet, daß** die Treiberstufe (OPV, T1) einen Operationsverstärker (OPV) aufweist, dessen Ausgang mit dem Steuereingang eines ersten Transistors (T1) zum Schalten verbundenen ist und daß als parallel geschaltetes Bauelement ein zweiter Transistor (T2) vorgesehen ist, der mit dem ersten Transistor (T1) leitend verbunden ist.

8. Zeichengenerator nach den Ansprüchen 3 und 7, **dadurch gekennzeichnet, daß** die Steuerspannung (URA) an einem Eingang des Operationsverstärkers (OPV) angelegt wird.

## Claims

1. Optical character generator (ZG) for an electrographic printing or copying device comprising
- a plurality of controllable light sources (LED) arranged in at least one row, and
- at least one means for controlling light sources (IC), which means contains per light source (LED) one switch means (SW1, ..., SW64) with a driver stage (OPV, T1) which is driven before activation and/or after deactivation of the light source (LED) such that a flow of current through a switchable component (T2) connected parallel to the light source (LED) is generated at its output so that the energy supply to the character generator (ZG) can temporarily ensue independent of the activation of the light sources (LED).

2. Optical character generator according to claim 1, **characterized in that** the flow of current is controllable and is in particular altered relatively slowly.

3. Optical character generator according to claim 2, **characterized in that** the control of the flow of current ensues via a control voltage (URA) that has a ramp curve.

4. Optical character generator according to one of the claims 1 to 3, **characterized in that** for activating a light source (LED) a flow of current through the parallel connected component (T2) is generated at the output of the driver stage (OPV, T1), which flow of current rises relatively slowly up to a predetermined amount, and then the light source (LED) is activated by shutting off the parallel connected component (T2), whereby the flow of current through the light source (LED) assumes the predetermined amount relatively quickly.

5. Optical character generator according to one of the claims 1 to 4, **characterized in that** for deactivating the light source (LED) the parallel connected component (T2) at the output of the driver stage (OPV, T1) is turned on, whereby the current previously flowing through the light source (LED) flows through the component (T2) after a relatively short time, and that subsequently the current flowing through the component (T2) drops relatively slowly with a predetermined characteristic.

6. Character generator according to one of the claims 1 to 5, **characterized in that** a parallel component (T2) is allocated to each light source (LED) and that neighboring parallel components (T2) are switched with time offset relative to one another.

7. Character generator according to one of the claims 1 to 6, **characterized in that** the driver stage (OPV, T1) has an operational amplifier (OPV), the output of which is connected to the control input of a first transistor (T1) for switching and that a second transistor (T2), which is conductively connected to the first transistor (T1), is provided as parallel connected component.

8. Character generator according to claims 3 and 7, **characterized in that** the control voltage (URA) is applied to an input of the operational amplifier (OPV).

## Revendications

1. Générateur optique de caractères (ZG) pour un appareil d'impression ou un copieur électrographique, comportant :
- une pluralité de sources lumineuses (LED) commandées, agencées suivant au moins une rangée, et
- au moins un moyen pour commander des sources lumineuses (IC), lequel comporte pour chaque source lumineuse (LED) un moyen de commutation (SW1,..., SW64) avec un étage d'attaque (OPV, T1) qui est commandé avant la mise en circuit et/ou après la mise hors circuit de la source lumineuse (LED) de telle façon qu'à sa sortie un courant soit généré transitoirement par un module (T2) commutable et commuté en parallèle par rapport à la source lumineuse (LED), de telle sorte que l'amenée d'énergie au générateur de caractères (ZG) puisse être effectuée transitoirement indépendamment de l'activation des sources lumineuses (LED).

2. Générateur optique de caractères selon la revendication 1, **caractérisé en ce que** le courant peut être commandé, et varie en particulier relativement lentement.

3. Générateur optique de caractères selon la revendication 2, **caractérisé en ce que** la commande du courant est effectuée par une tension de commande (URA) qui a l'allure d'une rampe.

4. Générateur optique de caractères selon l'une des revendications 1 à 3, **caractérisé en ce que**, pour mettre en circuit une source lumineuse (LED) en sortie de l'étage d'attaque (OPV, T1), un courant, d'intensité croissant relativement lentement jusqu'à atteindre une valeur prédéterminée, est généré par le module (T2) commuté en parallèle, puis la source lumineuse (LED) est mise en circuit en mettant hors circuit le module (T2) commuté en parallèle, d'où il résulte que l'intensité du courant circulant à travers la source lumineuse (LED) prend relativement rapidement la valeur prédéterminée.

5. Générateur optique de caractères selon l'une des revendications 1 à 4, **caractérisé en ce que**, pour mettre hors circuit la source lumineuse (LED) en sortie de l'étage d'attaque (OPV, T1, T2), le module (T2) commuté en parallèle est mis en circuit , d'où il résulte que le courant circulant auparavant dans la source lumineuse (LED) circule au bout d'un temps relativement court à travers le module (T2), et **en ce qu'**ensuite l'intensité du courant circulant dans le module (T2) chute relativement lentement avec une caractéristique prédéterminée.

6. Générateur optique de caractères selon l'une des revendications 1 à 5, **caractérisé en ce qu'**un module parallèle (T2) est associé à chaque source lumineuse (LED), et **en ce que** des modules parallèles adjacents (T2) sont commutés avec un décalage temporel.

7. Générateur optique de caractères selon l'une des revendications 1 à 6, **caractérisé en ce que** l'étage d'attaque (OPV, T1) comporte un amplificateur opérationnel (OPV) dont la sortie est reliée à l'entrée de commande d'un premier transistor (T1) pour réaliser la commutation, et **en ce qu'**il est prévu un second transistor (T2), comme module commuté en parallèle, qui est relié au premier transistor (T1).

8. Générateur optique de caractères selon les revendications 3 et 7, **caractérisé en ce que** la tension de commande (URA) est appliquée à une entrée de l'amplificateur opérationnel (OPV).
